# EUROPEAN PATENT SPECIFICATION

(11) **EP 4 517 291 B1**
(45) Date of publication and mention of the grant of the patent: **23.09.2026**
(21) Application number: 24196952.6
(22) Date of filing: 28.08.2024
(51) Int. Cl.: G01N 1/28, G01N 1/42, H01J 37/20

(54) **TEM GRIDS WITH LIQUID SPREADING LANES**
TEM-GITTER MIT FLÜSSIGKEITSVERTEILUNGSSPUREN
GRILLES TEM À VOIES D'ÉTALEMENT DE LIQUIDE

(30) Priority: 28.08.2023 US 202363579244 P
(43) Date of publication of application: 05.03.2025
(73) Proprietor: FEI COMPANY, Hillsboro, OR 97124 (US)
(72) Inventor: DE RUITER, Jolet, Eindhoven (NL); HENDRIKSEN, Bas, Eindhoven (NL)
(74) Representative: Robinson, Louise Frances

(56) References cited:
- EP-A1- 3 502 650
- CN-U- 219 121 841
- US-A1- 2011 253 908
- US-A1- 2017 025 250

## Description

### CROSS REFERENCE TO RELATED APPLICATIONS

### BACKGROUND

The present disclosure relates to a grid for sampling a liquid specimen. The grid may be for sampling a liquid specimen for transmission electron microscopy (TEM) analysis.

Samples for single-particle cryo-electron microscopy are conventionally prepared by manually pipetting buffer solution containing proteins on a TEM grid carrier. The grid is subsequently blotted by filter paper and vitrified in liquid ethane. In this process, a few microliters of sample may be applied to wet the entire grid, of which 99.99% is then removed. In addition, different blotting conditions (for example, variations in blot force and the irregular pattern of fibers in filter paper) may lead to unpredictable sample thickness.

Alternative ways of preparing samples have been developed to eliminate the blotting step. Some technologies dispense liquid in a controlled way but very locally, such as piezoelectric inkjet dispensing, pin printing technology, and microcapillary writing. Other technologies cover the entire grid using sprays, but they may suffer from distributions in droplet size and location, and sample losses.

US2011/0253908 describes a carrier, a carbon nanotube structure, and a protector. The carrier defines a first through opening. The provided defines a second through opening. The carbon nanotube structure is located between a surface of the carrier and a surface of the protector. The carbon nanotube structure covers at least part of the first through opening.

### SUMMARY

According to the present invention, there is provided a method of preparing a liquid specimen according to appended claim 1. The method includes providing a grid. The grid includes a first layer having a plurality of lanes and a backing material supporting the first layer, each lane having a first end configured to receive the liquid specimen, a second end opposite the first end, and a length extending from the first end to the second end. The backing material defines a bottom of each lane. The method also includes applying droplets of the liquid specimen onto the first end of each of the plurality of lanes such that the plurality of lanes is filled via spontaneous capillary flow.

Also described herein, but not falling under the scope of the appended claims, is a grid for sampling a liquid specimen. The grid includes a first layer and a backing material supporting the first layer. The first layer includes a plurality of lanes, each lane having a first end configured to receive a droplet of the liquid specimen, a second end opposite the first end, and a length extending from the first end to the second end.

Further described herein, but not falling under the scope of the appended claims, is a transmission electron microscopy (TEM) sample preparation system including a grid and an applicator. The grid is configured for sampling a liquid specimen. The grid includes a first layer having a plurality of lanes and a backing material supporting the first layer, each lane having a first end configured to receive the liquid specimen, a second end opposite the first end, and a length extending from the first end to the second end. The backing material defines a bottom of each lane. The applicator is configured to apply a droplet of the liquid specimen onto each lane such that spontaneous capillary flow of the liquid specimen occurs.

Other aspects of the disclosure will become apparent by consideration of the detailed description and accompanying drawings.

### BRIEF DESCRIPTION OF THE DRAWINGS

FIG. 1 is a schematic view of a grid for sampling a liquid specimen.
FIG. 2 is a top schematic view of a lane of the grid of FIG. 1.
FIG. 3A is a cross-sectional view of the lane of FIG. 2 taken through line 4-4.
FIG. 3B is a cross-sectional view of another embodiment of a lane.
FIG. 4 is a cross-sectional view of another embodiment of a lane.
FIG. 5A is a top schematic view of another embodiment of a lane of a grid.
FIG. 5B is a top schematic view of another embodiment of a lane of a grid.
FIG. 5C is a top schematic view of another embodiment of a lane of a grid.
FIG. 6 is a cross-sectional, perspective view of the lane of FIG. 2 taken through line 4-4 of FIG. 2.
FIG. 7 is a schematic diagram of an electronic control system and printer.
FIG. 8 is a flow chart depicting a method of preparing a liquid specimen.

### DETAILED DESCRIPTION

The present disclosure relates to a method as defined in claim 1. A sample preparation system 10, not falling under scope of the appended claims, for sampling a liquid specimen 14 is also described. The sample preparation system 10 is configured to prepare the liquid specimen 14 for analysis in a charged particle microscopy, such as by a transmission electron microscope (TEM). The illustrated application is only one example, and the sample preparation system 10 may be utilized in any sampling application, especially when sampling a liquid specimen 14.

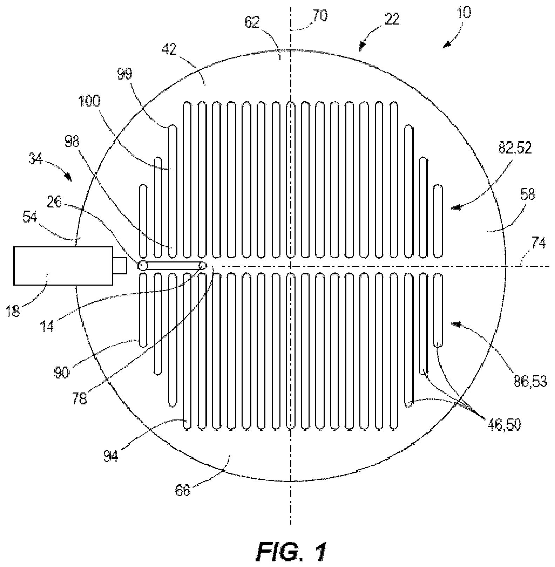

As illustrated in FIGS. 1-3, the sample preparation system 10 includes an applicator (which may be, for example, an inkjet printer 18) for applying or printing the liquid specimen 14 and a grid 22 for holding the liquid specimen 14. The inkjet printer 18 is configured to print a plurality of droplets 26 of the liquid specimen 14 onto the grid 22. The printer may precisely print droplets 26 such that a volume of the printed droplet is substantially the same as a volume of the portion of the grid 22 that the droplet 26 fills. That is, the droplets 26 are printed precisely such that they do not overflow the grid 22 or underfill the grid 22. In other embodiments the liquid specimen 14 may overfill the grid 22. In other embodiments, a different device may be used to place the liquid specimen 14 onto the grid 22 (e.g., a pipette, capillary, syringe, etc.). The droplet 26 volume may be less than 1 nanoliter to obtain a desirable film height. The printer 18 may print one droplet 26 or a plurality of droplets 26 onto the grid 22. The printer 18 is configured to print the droplets 26 onto a front side 34 of the grid 22. In alternate embodiments, the printer 18 may print the droplets 26 onto a back side 38 of the grid 22. Each droplet 26 of the liquid specimen 14 that is applied to the grid 22 has a droplet size 97. In the illustrated embodiment, the droplet size 26 is about 23 picoliters. For example, the droplet size 97 may be in a range of 1 picoliter to 1 nanoliter. In other embodiments, the droplet size 97 may be larger or smaller.

The grid 22 includes a backing material 40 and a first layer 42. The backing material 40 may be any of a plurality of different materials (e.g., foil, metal, plastic, ceramic, silicon nitride). The backing material 40 defines the back side 38 of the grid 22, and the first layer 42 defines the front side 34 of the grid 22. The backing material 40 and the first layer 42 are substantially the same shape and size. As described herein, both the backing material 40 and the first layer 42 are circular in shape. Alternatively,, the first layer 42 and the backing material 40 may be a different shape (e.g., square, rectangular, trapezoidal, etc.), or the first layer 42 may have a different shape from the backing material 40 (e.g., the first layer 42 may be circular and the backing material 40 may be square).

As described herein, the first layer 42 is hydrophilic and the backing material 40 is hydrophilic. In alternate embodiments, the first layer 42 may not be hydrophilic and/or the backing material 40 may not be hydrophilic.

The first layer 42 includes a plurality of slots 46. Each slot 46 defines a lane 50. The lanes 50 are configured to separate each droplet 26 of the liquid specimen 14 such that multiple specimens may be received on the grid 22.Each lane 50 may receive a different specimen or each lane 50 may receive the same specimen. For example, a first liquid specimen may be placed in a first half 52 of the plurality of lanes 50 and a second liquid specimen may be placed in a second half 53 of the plurality of lanes 50Each lane 50 may receive multiple liquid specimens 50. Alternatively, each of the plurality of lanes 50 may receive a different liquid specimen 14.The two or more different liquid specimens 14 may be placed in a single lane 50.The lanes 50 may have a single inlet configured to be fed by a single droplet 26. Alternately, multiple inlets may be configured to be fed by different droplets 26 and lead the droplets 26 to a single lane 50. Evaporation may be closely monitored and controlled while the printer 18 prints the droplets 26 into each lane 50 to inhibit one lane 50 from drying out before the next lane 50 is filled with the liquid specimen 14.

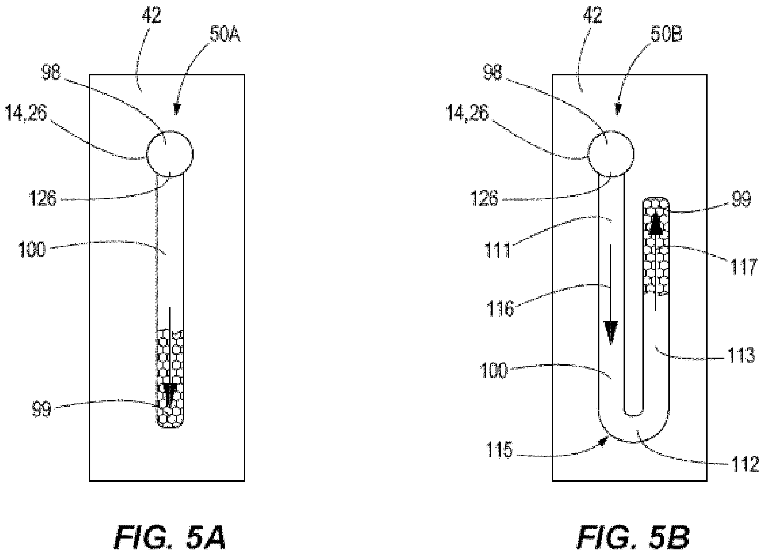

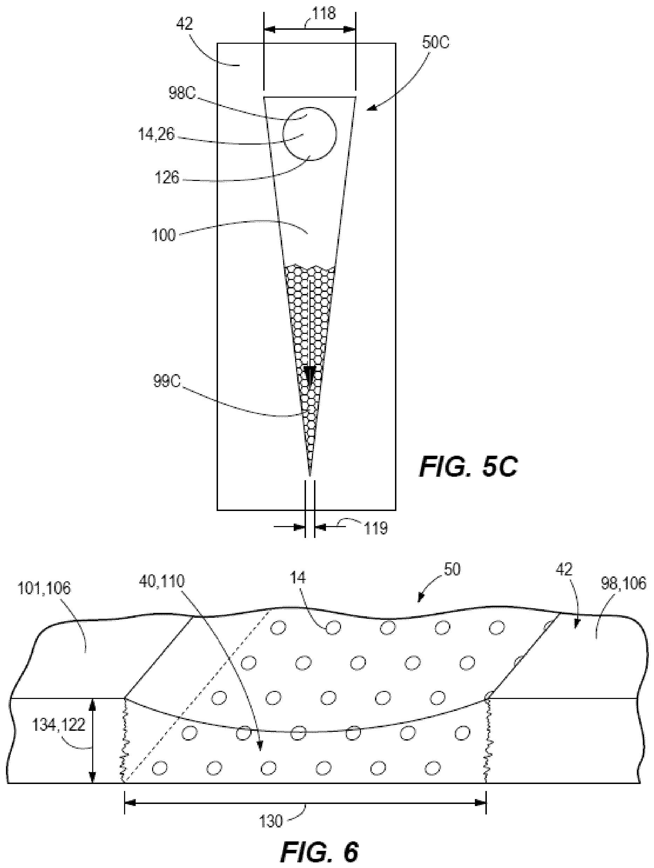

With respect to an orientation of the grid 22 shown in FIG. 1, the first layer 42 has a left edge 54, a right edge 58, a top edge 62, a bottom edge 66. A first axis 70 extends through the top edge 62 and the bottom edge 66. The first axis 70 may also be referred to as a longitudinal axis or a vertical axis. A second axis 74 extends through the left edge 54 and the right edge 58. The second axis 74 may also be referred to as a latitudinal axis or a horizontal axis. A solid portion 78 of the first layer 42 coincides with the latitudinal axis 74. A first set 82 of the lanes 50 is located above the solid portion 78, and a second set 86 of the lanes 50 is located below the solid portion 78. Each set of lanes 82, 86 extends from the solid portion 78 toward an outer perimeter of the first layer 42. The lanes 50 are spaced from the outer perimeter such that each lane 50 is completely bounded by the first layer 42. The first set of lanes 82 and the second set of lanes 86 are mirrored across the latitudinal axis 74. Because the first layer 42 is circular, the lanes 50 closest to the left edge 54 and the lanes 50 closest to the right edge 58 have shorter lengths 90 than lanes 50 near a middle of the first layer 42. The lanes 50 increase in length toward the longitudinal axis 70. As described herein, the first layer 42 has 42 total lanes 50 (e.g., 21 lanes in the first set of lanes 82, and 21 lanes in the second set of lanes 86. Alternatively, the first layer 42 may have fewer or more total lanes 50, and/or the first set of lanes 82 and the second set of lanes 86 may have different numbers of lanes 50. As described below (see FIGS. 5B and 5C), the lanes 50 may have different shapes or different patterns. For example, the lanes 50 may curve or radiate outward from a single inlet.

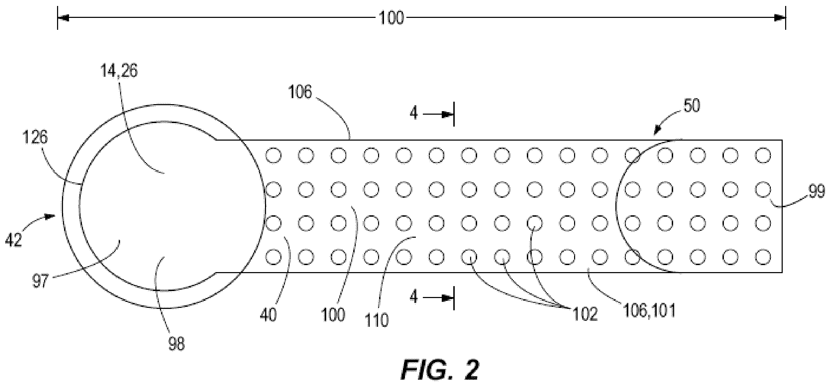

Referring to FIG. 2, the lanes 50 are linear in shape. Each of the plurality of lanes 50 has a first end 98 and a second end 99. The first end 98 is configured to receive the droplet 26 from the printer 18. The second end 99 is located opposite the first end 98 and may be configured to receive a second droplet of the same liquid specimen 50 or a second droplet of a second liquid specimen. Each lane 50 also has a length 100 extending from the first end 98 to the second end 99. Each lane 50 further includes a rounded portion 126 at the first end 98. The rounded portion 126 is larger than a remainder of the lane 50 to facilitate receiving the droplet 26. Each lane 50, thereby, defines a flow path for the liquid specimen 14 from the first end 98 to the second end 99. The lanes 50 may not include the rounded portion 126 and the droplets 26 may be printed directly into the lanes 50. Alternatively, the rounded portion 126 may be any of a plurality of different shapes (e.g., triangular, square, etc.).

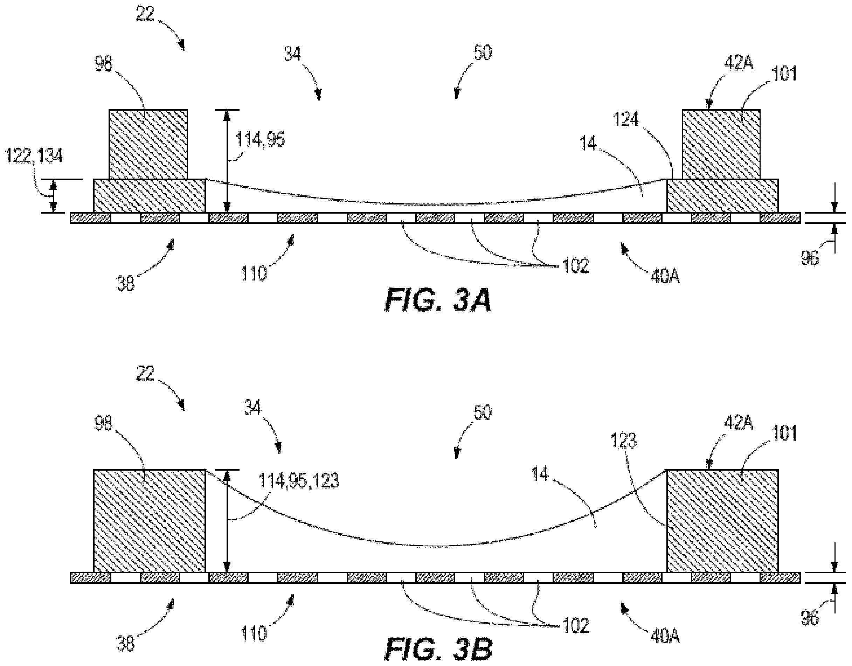

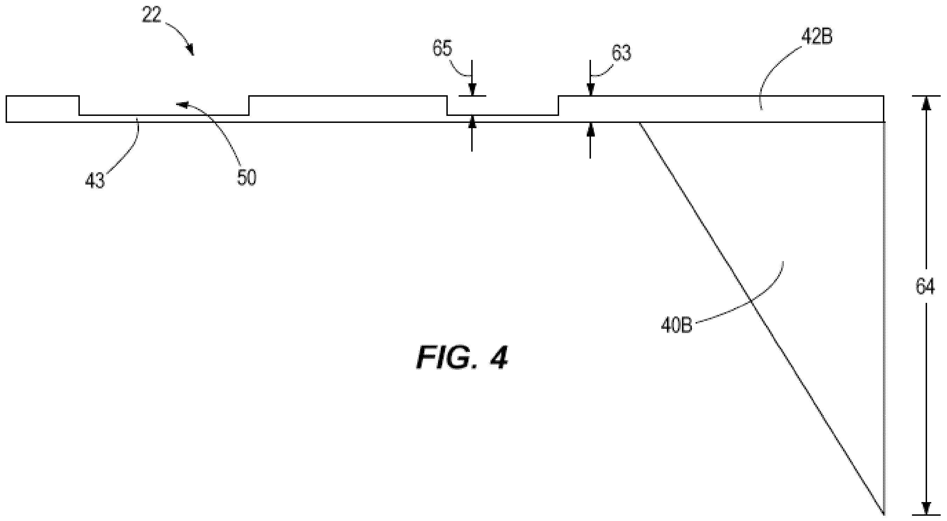

As described herein (See FIGS. 3A and 3B), the first layer 42 may be a mesh 42A. In alternate embodiments (See FIG. 4), the first layer 42 may be a silicon nitride foil 42B and the backing material 40 may be a silicon wafer 40B upon which the silicon nitride foil 42B is suspended.

As shown in FIG. 3A, the mesh 42A includes a plurality of bars 101. The bars 101 define sidewalls 106 of each lane 50. In the illustrated embodiments, the bars 101 extend parallel to each other such that the lanes are parallel to one another. Each bar 101 has a bar height 114. The bar height 114 is equivalent to the mesh thickness 95. The backing material 40 is coupled to the mesh 42A and defines a bottom 110 of the lanes 50. The illustrated backing material also defines holes 102. The holes 102 are significantly smaller than each lane 50 such that a plurality of holes 102 fit across of width of each lane 50. The holes 102 may be specifically positioned along the lanes 50 such that the holes 102 do not partially overlap with the bars 101 to inhibit leaking of the liquid specimen 14. Alternatively, the backing material 40 may have a lower hydrophilicity than the mesh 42A to prevent leaking of the liquid specimen 14.

The mesh 42A has a mesh thickness 95, and the backing material 40 has a backing thickness 96. As described herein, the mesh thickness 95 is about 15 micrometers, and the backing thickness 96 is about 10 nanometers. For example, the mesh thickness 95 may be in a range from 5-35 micrometers, and the backing thickness 96 may be in a range from 5-50 nanometers. Alternatively, the mesh thickness 95 and/or the backing thickness 96 may be thicker or thinner.

With reference to FIGS. 3A and 3B, each bar 101 defines the specimen thickness 122 of the liquid specimen 14. The specimen thickness 122 in the present embodiments varies between each bar 101 or sidewall 106. The specimen thickness 122 may vary between 1 micrometer and 10 micrometers. In other embodiments, the specimen thickness 122 may have other nominal thicknesses. The specimen thickness 122 varies between the sidewalls 106 because the liquid specimen 14 defines a concave meniscus in the lane 50. In other embodiments, the specimen thickness 122 may be constant or convex (i.e., in cases of overfilling). In FIG. 3A, each bar 101 includes a ridge 124 relative to the backing material 40. The ridge 124 restricts the specimen thickness 122 such that the specimen thickness 122 is less than that of the mesh thickness 95. In in FIG. 3B, the bars 101 do not include the ridge 124. Instead, a portion of a thickness 123 of the liquid specimen 14 closest to the bar 101 is the same as the mesh thickness 95. Different features may be used to restrict the thickness 122 of the liquid specimen 14. For example, a portion of the bars 101 may be hydrophobic to restrict the thickness 122.

In FIG. 4, the first layer 42 is the silicon nitride foil 42B. The foil 42B is suspended on the silicon wafer 40B with the lanes 50 etched into the foil 42B. Specifically, the lanes 50 are etched into the foil 42B without breaking through a bottom wall 43 of the foil 42B. Side walls 106 may be formed while etching the lanes 50 into the foil 42B.A plurality of holes (not shown) may be etched in the bottom wall 43 of each lane 50. The holes may be similar in width to each lane 50 such that each lane 50 may only fit a single hole across the width of the lane. Alternatively, multiple holes may be etched across the width of each lane 50.

The foil 42B has a foil thickness 63, the wafer 40B has a wafer thickness 64, and the lanes 50 have a lane thickness 65. As described herein, the foil thickness is about 350 nanometers, the wafer thickness is about 100 micrometers, and the lane thickness is about 300 nm. The foil thickness 63 may be in a range from 100 to 500 nanometers, the wafer thickness 64 may be in a range from 50 to 300 micrometers, and the lane thickness 65 may be in a range from 100 to 500 nanometers. The foil thickness 63, wafer thickness 64, and/or lane thickness 65 may be thicker or thinner. The wafer thickness 64 is configured to be sizably larger than the foil thickness 63 to provide robust support and rigidity for the foil 42B.

The lane thickness 65 may be between 100 and 500 nanometers. As such, the specimen thickness 122 may similarly vary between 100 and 500 nanometers. The specimen thickness 122 may have other nominal thicknesses. The specimen thickness 122 varies between the sidewalls 106 because the liquid specimen 14 defines a concave meniscus in the lane 50.The specimen thickness 122 may be constant or convex (e.g., in cases of overfilling). The liquid specimen 14 may overfill the grid 22 due to the lane thickness 65.

With reference to FIGS. 5A-5C, the lanes 50 may have different shapes. For example, lanes 50A (FIG. 5A) may be linear, lanes 50B (FIG. 5B) may be curved 50B, or lanes 50C (FIG. 5C) may be tapered 50C. The linear lanes 50A are similar to the lanes 50 shown in FIGS. 1 and 2. The linear lanes 50A each extend generally parallel to one another. In alternate embodiments, the linear lanes 50A may extend transverse to one another. For example, the linear lanes 50A may radiate from a center portion of the grid 22. Alternatively, some of the linear lanes 50A may extend parallel to the longitudinal axis 70, and some of the linear lanes 50A may extend perpendicular to the longitudinal axis 70.The lanes 50 may branch from a single lane into multiple lanes. The multiple lanes may have the same width and height as the single lane, or they may have a different width or height. Additionally, each of the multiple lanes may have a different width or height in comparison to one another.

As shown in FIG. 5B, each curved lane 50B includes a first portion 111, a second portion 112, and a third portion 113. The first portion 111 and the third portion 113 are generally linear and parallel. The first portion 111 and the third portion 113 may be substantially transverse. The second portion 112 is between the first portion 111 and the third portion 113. The second portion 112 defines a bend 115 configured to curve and change a direction of a flow path of the liquid specimen 14 such that the liquid specimen 14 in the first portion 111 follows a first flow path 116 and the liquid specimen 14 in the third portion 113 follows a second flow path 117.The curved lane 50B may include one bend or a plurality of bends (e.g., the lane 50B may be S-shaped or meander).

As shown in FIG. 5C, each tapered lane 50C includes a first end 98C having a first width 118 and a second end 99C having a second width 119. The first width 118 is larger than the second width 119 such that a width of the tapered lane 50C decreases from the first end 98C to the second end 99C. The tapered lane 50C tapers continuously from the first end 98C to the second end 99C. More particularly, the tapered lane 50C tapers linearly from the first end 98C to the second end 99C.The tapered lane 50C may taper non-linearly and/or non-continuously between the first end 98C and the second end 99C.The second width 119 may be larger than the first width 118 such that the width of the lane 50C increases from the first end 98 to the second end 99.

Referring to FIG. 6, each lane 50 has a width 130 and a height 134. The width 130 is defined by the distance between each bar 101. The height 134 is defined by the bar height 114. The width 130 and the height 134 may define any of a plurality of aspect ratios. The aspect ratio and the hydrophilicity of the grid 22 cause spontaneous capillary filling (SFC) to occur. Each lane 50 may have a different width 130 and/or height than the other lanes 50. Additionally, each lane 50 may have a different shape.

For SFC to occur the aspect ratio may be below a critical aspect ratio which is determined by the contact angle between liquid and the walls of the lane 50. For example, assuming a constant contact angle of 30 degrees, the critical aspect ratio is estimated to be 13. Alternatively, assuming a constant contact angle of 20 degrees, the critical aspect ratio is estimated to be 31. Other critical aspect ratios are obtained for other contact angles, or heterogeneous contact angles (i.e. different contact angle of the first layer 42 and foil 40). Following the principle of SFC, the droplet 26 spreads throughout the lane 50 until the lane 50 has a substantially constant thickness of the liquid specimen 14 throughout the length of the lane 50.

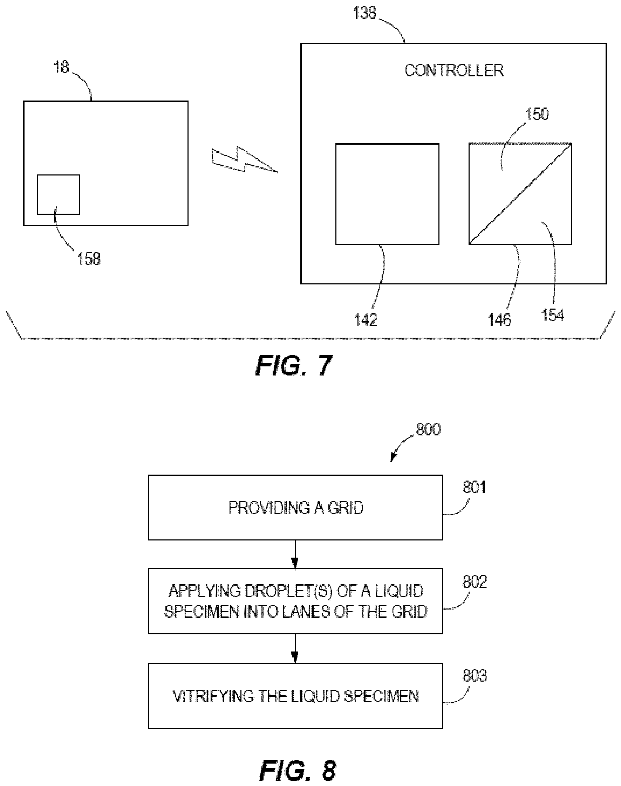

With reference to FIG. 7, the sample preparation system 10 described herien includes an electronic controller 138 configured to automatically or semi-automatically control the inkjet printer 18. The controller 138 may include a programmable processor 142 (e.g., a microprocessor, a microcontroller, or another suitable programmable device) and a memory 146 such as a non-transitory memory. The memory 146 may include, for example, a program storage area 150 and a data storage area 154. The program storage area 150 and the data storage area 154 can include combinations of different types of memory 146, such as read only memory ("ROM"), random access memory ("RAM") (e.g., dynamic RAM ["DRAM"], synchronous DRAM ["SDRAM"], etc.), electrically erasable programmable read-only memory ("EEPROM"), flash memory, a hard disk, an SD card, or other suitable magnetic, optical, physical, electronic memory devices, or other data structures. Programming may be coded or learned.

As one example, the electronic controller 138 may be configured to control movement of the printer 18. For example, the electronic controller 138 may control rotation of the printer 18. The electronic controller 138 may also be configured to control the position or linear translation of the printer 18 in 3-dimensional space, e.g., to move the printer 18 to print the droplet 26 into each lane 50, which may include moving in the X-direction, the Y-direction, and/or the Z-direction, in any combination or orientation. The electronic controller 138 may further be configured to communicate with the printer 18 when it is appropriate to print (i.e., when the printer 18 is in the correct position above a lane 50). This may be done by using a sensor 158 to detect the location of the printer 18 and the corresponding lanes 50. The sensor may be an optical sensor, proximity sensor, accelerometer, or any other sensor of the like.

FIG. 8 is a flowchart depicting an example of a method 800 of preparing the liquid specimen 14 for analysis in a charged particle microscope (e.g., a transmission electron microscope, scanning electron microscope, etc.) within the scope of claim 1. Although the method includes particular steps, not all of the steps need to be performed or need to be performed in the order presented. In some embodiments, the method may include additional steps. At least some of the method may be carried out by the electronic controller 138.

At step 801, a user provides the grid 22. The grid 22 includes the first layer 42 on the front side 34 and the backing material 40 on the back side 38. In the embodiment of this method, the backing material 40 is a foil. The first layer 42 defines the plurality of lanes 50, and the backing material 40 supports the first layer 42. Each lane 50 includes the first end 98 and the second end 99. The first end 98 is configured to receive the liquid specimen 14 in a later step (step 802). The second end 99 is opposite the first end 98. The length 100 extends from the first end 98 to the second end 99. The backing material 40 defines the bottom 110 of each lane 50. The lanes 50 have the height 134 and the width 130 and the aspect ratio of, for example, 20. Prior to this step, the first layer 42 and the grid 22 may be aligned by the user or by an alignment device (not shown) such as a micromanipulator.

At step 802, droplets 26 of the liquid specimen 14 are applied into each lane 50. The droplets 26 are inserted on the first layer 42 side. The droplets 26 are further inserted onto the first end 98 of each of the plurality of lanes 50. Each droplet 26 may be the same liquid specimen 14, or each droplet 26 may be a different liquid specimen 14. In some embodiments, applying the droplets 26 includes printing the droplets 26 of the liquid specimen 14 using the inkjet printer 18. The printer 18 may use the sensor 158 to detect the location of each lane 50. In other embodiments or methods, the printer 18 may print the droplet 26 into each lane 50 on the back side 38. In still other embodiments, the droplets 26 may be applied by a pipette or other suitable tool. In response to the hydrophilicity and aspect ratio of the lanes 50, each droplet 26 spontaneously spreads through each lane 50 via spontaneous capillary flow.

At step 803, the liquid specimen 14 is vitrified. In some embodiments, the liquid specimen 14 is vitrified by inserting the grid 22 into a bath of liquid ethane to complete the sample preparation process. The grid 22 may be inserted into the bath by the user, by a micromanipulator, or a manipulation tool (e.g., tweezers, clamps, etc.). Alternatively, a jet of the liquid ethane may be directed at the grid 22. In alternate embodiments, the liquid specimen 14 may be inserted into a bath of a different liquid.

After the liquid specimen is prepared, a user may analyze the liquid specimen using a charged particle microscope, such as a TEM.

The aspect ratio and hydrophilicity of the lanes 50 provide advantages. If the lanes 50 had an aspect ratio such that SCF did not occur, the liquid specimen 14 may have a non-uniform thickness 122 or the lanes 50 may not fill at all. The aspect ratio and hydrophilicity of the lanes 50 ensure that SCF occurs, which allows for a reproducible liquid specimen thickness 122. This provides for repeatability of sample thickness 122 during each sample preparation procedure. Evaporation of the liquid specimen 14 may also be taken advantage of to determine the final thickness 122. Alternately, a filter paper may be used to blot and thin the liquid specimen 14. The filter paper may be used to blot the entire lane 50 or to blot only the inlet. The inkjet printer 18 provides further advantages. If a sample (such as the liquid specimen 14) is inserted onto the grid 22 without a printer 18, sample loss may occur. The use of the inkjet printer 18 reduces sample losses by precisely printing small droplets 26 of the liquid specimen 14 into each lane 50 - a precision that could not be easily replicated by another tool (e.g., a pipette).

## Claims

1. A method (800) of preparing a liquid specimen (14), the method comprising:
providing (801) a grid (22), the grid including a first layer (42) comprising a plurality of lanes (50) and a backing material (40) supporting the first layer, each lane having a first end (98) configured to receive the liquid specimen, a second end (99) opposite the first end, and a length (100) extending from the first end to the second end, the backing material defining a bottom (110) of each lane; **characterized in that** the method further comprises
applying (802) droplets (26) of the liquid specimen onto the first end of each of the plurality of lanes such that the plurality of lanes is filled via spontaneous capillary flow.

2. The method of claim 1, further comprising vitrifying (803) the liquid specimen.

3. The method of claim 1, wherein applying the droplets includes printing, using an inkjet printer (18), the droplets of the liquid specimen.

4. The method of claim 1, further comprising controlling evaporation of the liquid specimen.

5. The method of claim 1, further comprising blotting the liquid specimen to control specimen thickness (122).

## Patentansprüche

1. Verfahren (800) zum Herstellen einer Flüssigprobe (14), wobei das Verfahren Folgendes umfasst:
Bereitstellen (801) eines Gitters (22), wobei das Gitter eine erste Schicht (42) aus einer Vielzahl von Bahnen (50) und ein Trägermaterial (40) aufweist, das die erste Schicht trägt, wobei jede Bahn ein erstes Ende (98), das zur Aufnahme der Flüssigprobe konfiguriert ist, ein zweites Ende (99), das gegenüber vom ersten Ende angeordnet ist, und eine Länge (100), die sich vom ersten Ende zum zweiten Ende erstreckt, aufweist, wobei das Trägermaterial den Boden (110) jeder Bahn definiert; **dadurch gekennzeichnet, dass** das Verfahren ferner das Auftragen von (802) Tröpfchen (26) der Flüssigprobe auf das erste Ende jeder der Vielzahl von Bahnen umfasst, derart,
dass die Vielzahl von Bahnen über spontanen Kapillarfluss gefüllt wird.

2. Verfahren nach Anspruch 1, das ferner das Vitrifizieren (803) der Flüssigprobe umfasst.

3. Verfahren nach Anspruch 1, wobei das Auftragen der Tröpfchen das Drucken der Tröpfchen der Flüssigprobe mit einem Tintenstrahldrucker (18) beinhaltet.

4. Verfahren nach Anspruch 1, das ferner das Kontrollieren der Verdunstung der Flüssigprobe umfasst.

5. Verfahren nach Anspruch 1, das ferner das Blotten der Flüssigprobe, um die Probendicke (122) zu kontrollieren, umfasst.

## Revendications

1. Procédé (800) de préparation d'un échantillon liquide (14), le procédé comprenant :
la mise à disposition (801) d'une grille (22), la grille comprenant une première couche (42) formée d'une pluralité de canaux (50) et un matériau support (40) soutenant la première couche, chaque canal ayant une première extrémité (98) conçue pour recevoir l'échantillon liquide, une deuxième extrémité (99) à l'opposée de la première et une longueur (100) s'étendant de la première extrémité à la deuxième extrémité, le matériau support définissant le fond (110) de chaque canal ; **caractérisé en ce que** le procédé comprend en outre l'application (802) de gouttes (26) d'échantillon liquide sur la première extrémité de chacun des différents canaux,
de sorte que ceux-ci se remplissent par écoulement capillaire spontané.

2. Le procédé selon la revendication 1, comprenant en outre la vitrification (803) de l'échantillon liquide.

3. Le procédé selon la revendication 1, dans lequel l'application des gouttes comprend l'impression, à l'aide d'une imprimante à jet d'encre (18), des gouttes de l'échantillon liquide.

4. Le procédé selon la revendication 1, comprenant en outre le contrôle de l'évaporation de l'échantillon liquide.

5. Le procédé selon la revendication 1, comprenant en outre l'absorption de l'excès d'échantillon liquide pour contrôler l'épaisseur de l'échantillon (122).
